# EUROPÄISCHE PATENTSCHRIFT

(11) **EP 0 529 281 B1**
(45) Veröffentlichungstag und Bekanntmachung des Hinweises auf die Patenterteilung: **20.05.1998**
(21) Anmeldenummer: 92112220.6
(22) Anmeldetag: 17.07.1992
(51) Int. Cl.: G01R 1/067, G01R 31/02, F02P 17/00

(54) **Verfahren zum Detektieren einer Kontaktierung von Messleitungen**
Method of detecting a contacting of measuring leads
Procédé de détection d'une mise en contact des lignes de mesure

(30) Priorität: 23.08.1991 DE 4127969
(43) Veröffentlichungstag der Anmeldung: 03.03.1993
(73) Patentinhaber: ROBERT BOSCH GMBH, 70442 Stuttgart (DE)
(72) Erfinder: Etzold, Peter, Dipl.-Ing., W-7333 Ebersbach-Rosswaelden (DE)

(56) Entgegenhaltungen:
- EP-A- 0 051 290
- EP-A- 0 344 349
- EP-A- 0 414 142
- DE-A- 3 841 739
- DE-A- 4 018 895
- FR-A- 2 624 561
- US-A- 4 337 515
- US-A- 4 401 949
- US-A- 4 847 563

## Beschreibung

### Stand der Technik

Die Erfindung geht aus von einem Verfahren von Detektieren einer Kontaktierung von Meßleitungen nach der Gattung des Hauptanspruchs. Für die Ermittlung von zuverlässigen Meßergebnissen ist eine sichere Kontaktierung von Meßleitungen eines elektronischen Meßgeräts mit einem Prüfling Vorraussetzung. Bei Meßgeräten, die mit nur wenigen Leitungen mit dem Prüfling verbunden sind, kann eine Bedienperson durch einfache Sichtkontrolle feststellen, ob eine Kontaktierung vorliegt, ohne den Überblick zu verlieren. Bei Meßgeräten mit zahlreichen Meßleitungen, die beispielsweise an relativ weit voneinander entfernt liegenden Meßpunkten des Prüflings anzuschließen sind, kann diese Übersicht nicht in allen Fällen gegeben sein. Weiterhin schließt eine einfache Sichtkontrolle fehlerhafte Kontaktierungen nicht immer aus.

Aus US-A- 4 337 515 ist bekannt, das an der Meßleitung liegende Signal über eine Spannungsteilerschaltung mit der weiteren Auswerteschaltung zu verbinden, wobei die Spannungsteilerschaltung einen relativ hochohmigen widerstand enthält, der das Ruhepotential an der Meßleitung festlegt.

Der angeschlossene Prüfling, dessen Innenwiderstand im Vergleich zum hochohmigen widerstand des Spannungsteiler gering sein muß, zieht das Potential auf einen anderen Wert als das Ruhepotential. Die Auswerteschaltung kann zwischen einer fehlerhaften oder ordnungsgemäßen Kontaktierung der Meßleitung mit dem Prüfling dadurch unterscheiden, daß bei ordnungsgemäßer Kontaktierung sich das Potential an der Meßleitung vom Ruhepotential unterscheidet.

Der Erfindung liegt die Aufgabe zugrunde, ein Verfahren zum Detektieren einer Kontaktierung von Meßleitungen mit einem Prüfling anzugeben, das unabhängig von einer Bedienperson im Meßgerät selbstständig abläuft.

Die Aufgabe wird durch die im Hauptanspruch angegebenen Merkmale gelöst.

### Vorteile der Erfindung

Das erfindungsgemäße Verfahren weist den Vorteil auf, daß fehlerhafte Meßergebnisse, die durch eine fehlerhafte Kontaktierung von Meßleitungen eines elektronischen Meßgeräts mit einem Prüfling weitgehend ausgeschlossen sind. Das erfindungsgemäße Verfahren wertet eine Gleichspannungskompontente eines zu erfassenden Signales aus, die nur dann vorhanden ist, wenn die Kontaktierung der Meßleitung mit dem Prüfling in Ordnung ist. Vorraussetzung ist das Vorhandensein einer solchen Gleichspannungskomponente im zu erfassenden Signal.

Besonders vorteilhaft ist das erfindungsgemäße Verfahren verwendbar bei Meßgeräten, die zahlreiche Meßleitungen aufweisen, die an unterschiedlichen Stellen des Prüflings anzuschließen sind. Ein derartiges Meßgerät ist beispielsweise ein Testgerät für elektrische oder elektronische Komponenten von Kraftfahrzeugen. Bei diesen Motortestern kommt erschwerend hinzu, daß die verschiedenen Meßleitungen, die zu unterschiedlichen Orten des Kraftfahrzeugs führen, und der Motortester relativ weit voneinander entfernt sein können. Ein einfacher Blickkontakt zwischen beispielsweise einer Anzeige des Motortesters und den Kontaktierungen der Meßleitungen ist nicht mehr gegeben.

Eine universelle Auslegung der Testgeräte, beispielsweise Motortester, die eine Analyse von Mehrzylindermotoren mit bis zu 12 Zylindern ermöglichen, führt dazu, daß beispielsweise bei Zündungsmessungen bis zu 12 Meßleitungen an die einzelnen Zündübertrager heranzuführen sind. Bei der Diagnose von Motoren mit weniger als 12 Zylindern werden nicht alle dieser Meßleitungen benötigt, die dann, sofern sie nicht unmittelbar beim Testgerät abgenommen werden, die Übersicht erschweren. Insbesondere können in lose herumliegende Meßleitungen Signale eingekoppelt werden, die irrtümlich als Meßsignale interpretiert werden. Neben einer transformatorischen Kopplung ist insbesondere eine kapazitive Signalkopplung möglich, wobei die eingekoppelten Signale bei Messungen an Hochspannungs-Zündanlagen beträchtliche Pegel annehmen können.

Das erfindungsgemäße Verfahren ist insbesondere auch für neue Meßgeräte, insbesondere Kraftfahrzeug-Testgeräte geeignet, welche nicht nur festlegen, welche Meßleitungen von mehreren vorhandenen Leitungen mit dem Prüfling kontaktiert sind, sondern welche anhand einer Signalauswertung intern festlegen, an welchem Meßpunkt die Leitung angeschlossen ist. Bei dem weiter oben erwähnten Beispiel der Zündungsmessung an einem 12-Zylinder-Motor stellt dies eine erhebliche Arbeitserleichterung dar, weil die Zuordnung der 12 Meßleitungen zu den Zylindern keine Rolle mehr spielt.

Vorteilhafte Weiterbildungen und Verbesserungen des erfindungsgemäßen Verfahrens ergeben sich aus Unteransprüchen. Vorteilhaft ist die Maßnahme, daß der Vergleich des an der Meßleitung abgreifbaren Signals mit der Schwelle zum Feststellen einer Gleichspannungskomponente erst dann vorgenommen wird, wenn das Signal einen vorgebbaren Pegel überschritten hat. Die Einbeziehung dieses zusätzlichen Kriteriums erhöht die Detektionssicherheit, insbesondere bei Anwendung des erfindungsgemäßen Verfahrens in Meßgeräten, insbesondere in Zündungs-Meßgeräten, die impulsförmige Signalanteile auswerten, deren Amplitude zumindest kurzzeitig eine mittlere Amplitude um ein Mehrfaches übersteigt.

Eine andere Maßnahme zur Erhöhung der Detektionssicherheit ist dadurch gegeben, daß eine Kontaktierung erst dann als sicher angenommen wird, wenn die Gleichspannungskomponente die vorgegebene Schwelle mehr als einmal überschritten hat. Sofern auch die Pegelüberschreitung in das Verfahren einbezogen ist, wird auch dort die Detektionssicherheit erhöht, wenn die Pegelüberschreitung und die jeweils danach liegende Schwellenüberschreitung der Gleichspannungskomponente mehrmals nacheinander auftreten.

Weitere vorteilhafte Weiterbildungen und Verbesserungen des erfindungsgemäßen Verfahrens werden anhand der folgenden Beschreibung näher erläutert.

### Zeichnung

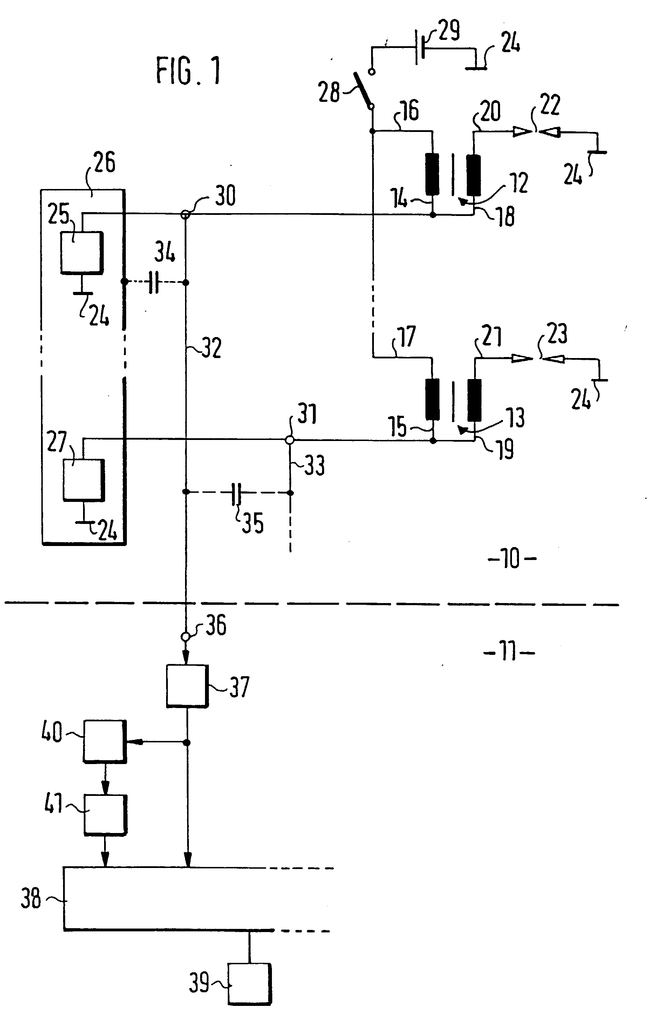

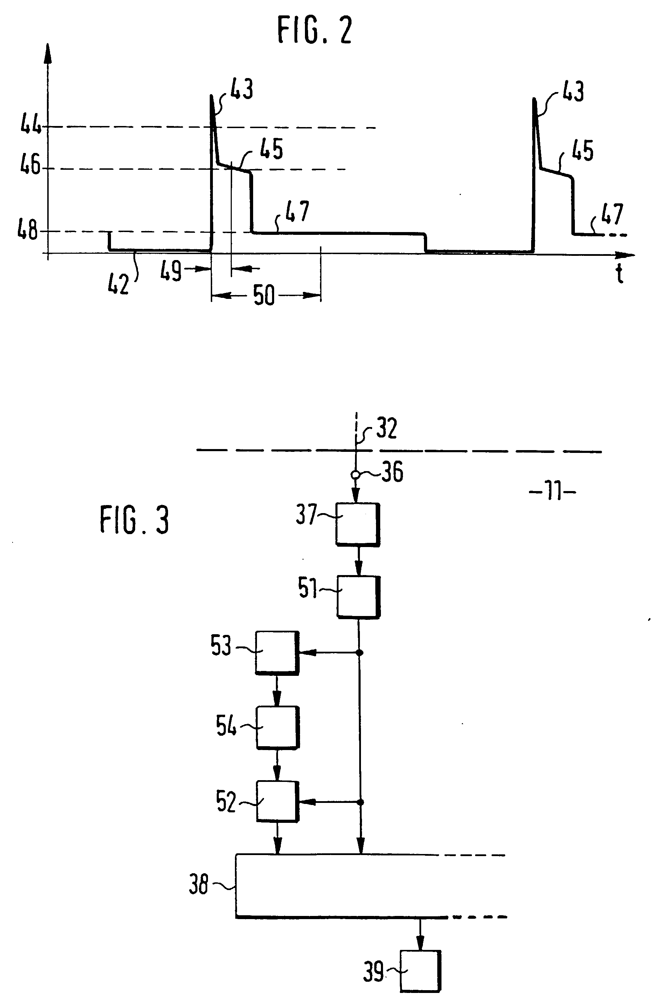

Figur 1 zeigt ein Blockschaltbild eines Meßgeräts, das über eine Meßleitung mit einem Prüfling kontaktiert ist, Figur 2 zeigt einen im Prüfling auftretenden Signalverlauf und die Figuren 3 und 4 zeigen Blockschaltbilder unterschiedlicher Ausgestaltungen des Meßgeräts.

In Figur 1 ist als Beispiel eines Prüflings 10 eine Zündanlage gezeigt, die strichliniert von einem Meßgerät 11 abgetrennt ist. Die Zündanlage 10 enthält zwei Zündspulen 12, 13, die jeweils erste Primäranschlüsse 14, 15, zweite Primäranschlüsse 16, 17, erste Sekundäranschlüsse 18, 19 sowie zweite Sekundäranschlüsse 20, 21 aufweisen. Die zweiten Sekundäranschlüsse 20, 21 der Zündspulen 12, 13 sind jeweils mit den Zündkerzen 22, 23 verbunden, die jeweils an eine Masse 24 geschaltet sind. Der erste Primäranschluß 14 der Zündspule 12, der mit dem ersten Sekundäranschluß 18 verbunden ist, ist weiterhin mit einem ersten Schalter 25 verbunden, der in einem Zündungsschaltgerät 26 angeordnet ist. Der erste Primäranschluß 15 der Zündspule 13, der mit dem ersten Sekundäranschluß 9 verbunden ist, ist weiterhin mit einem zweiten Schalter 27 verbunden, der ebenfalls im Zündungsschaltgerät 26 liegt. Die beiden Schalter 25, 27 die jeweils gegen Masse 24 geschaltet sind, sind beispielsweise Endstufen-Schalttransistoren des Zündungsschaltgeräts 26. Die in der Umrandung des Zündungsschaltgeräts 26 eingetragenene Punkte bedeuten, daß das Zündungsschaltgerät 26 neben den zwei gezeigten Schaltern 25, 27 weitere derartige Schalter enthalten kann. Ebenso bedeuten die Punkte in der Verbindungsleitung zwischen dem zweiten Primäranschluß 16 der Zündspule 12 und dem zweiten Primäranschluß 17 der Zündspule 13, daß diese Leitung zu weiteren Zündspulen führen kann, deren Anzahl der Anzahl der Schalter 25, 27 im Zündungsschaltgerät 26 entsprechen kann. Diese Verbindungsleitung führt zu einem Zündungsschalter 28, der die Zündanlage 10 mit einer an Masse 24 geschalteten Batterie 29 verbindet. An den zu den ersten Primäranschlüssen 14, 15 der Zündspulen 12, 13 führenden Leitungen sind jeweils Kontaktierungen 30, 31 vorgesehen, an die Meßleitungen 32, 33 angeschlossen sind, die zum Meßgerät 11 führen.

Zwischen dem Zündungsschaltgerät 26 und der Meßleitung 32 ist strichliniert ein Kondensator 34 eingetragen. Der Kondensator 34 symbolisiert eine Streukapazität, die zwischen der Meßleitung 32 und den elektrischen Komponenten der Zündanlage 10 auftritt. Zwischen den Meßleitungen 32, 33 ist ein weiterer Kondensator 35 strichliniert eingetragen, der eine Streukapazität zwischen den Meßleitungen 32, 33 symbolisiert. Die Kondensatoren 34, 35 sind deshalb strichliniert eingetragen, weil sie als eigenständige Bauelemente nicht vorhanden sind.

Die Meßleitungen 32, 33 führen über jeweils eine Verbindungsstelle 36 zum Prüfgerät 11. Das Meßgerät 11 enthält eine Eingangsschaltung 37, die beispielsweise eine Pegelanpassung oder beispielsweise ein Kompensationsnetzwerk enthält.

Nach dem Passieren der Eingangsschaltung 37 gelangt das Meßsignal in eine Signalauswertung 38, an die beispielsweise eine Anzeige 39 angeschlossen ist. Das Eingangssignal gelangt weiterhin an einen Mittelwertbildner 40, der ein Ausgangssignal an einen Komparator 41 abgibt. Der Komparator 41 gibt ein Signal an die Signalauswertung 38 ab.

In Figur 2 ist ein Signalverlauf gezeigt, der in der Zündeinlage 10 an den Kontaktierungen 30, 31 abgreifbar ist. Dieses Signal wird als primärseitiges Zündsignal bezeichnet. Bei geschlossenem Zündungsschalter 28 und bei ebenfalls geschlossenem Schalter 25, 27 fließt in der Primärwicklung der Zündspule 12, 13 ein Strom, der mit der Zeit zunimmt. Die an der Kontaktierung 30, 31 abgreifbare Spannung weist bis auf eine Sättigungsspannung der Schalter 25, 27 die gegebenenfalls vorhanden ist, ein Potential auf, das nahezu auf Masse 24 liegt. Dieser in Figur 2 mit dem Bezugszeichen 42 eingetragene Zeitabschnitt ist die Schließphase. Im Anschluß an die Schließphase 42 öffnet der Schalter 25, 27, so daß ein Umschwingvorgang des durch die Primärwicklung der Zündspule 12, 13 fließenden Stroms auf einen in Figur 1 nicht gezeigten Kondensator stattfindet. Eine schnelle Stromänderung hat eine hohe induzierte Spannung zur Folge, die als Zündspannung auftritt. Eine in Figur 2 gezeigte Zündnadel 43 weist eine Amplitude von bis zu 300 V auf. Eingetragen ist ein Pegel 44, der von der Zündnadel 43 mit Sicherheit überschritten wird. An die Zündnadel 43 schließt sich eine Brennphase 45 an, während der ein Zündfunke an der Zündkerze 22, 23 anliegt. In Figur 2 ist eine erste Schwelle 46 eingetragen, welche die Spannung während der Brennphase 45 übersteigt. Im Anschluß an die Brennphase 45 liegt eine Öffnungsphase 47, während welcher der Schalter 25, 27 geöffnet ist. In Figur 2 ist eine zweite Schwelle 48 eingetragen, die der Spannung während der Öffnungsphase entspricht.

Eingetragen sind weiterhin zwei Zeitintervalle, wobei das erste Zeitintervall 49 der ersten Schwelle 46 und das zweite Intervall 50 der zweiten Schwelle 48 zugeordnet ist.

Figur 3 zeigt eine Ausgestaltung des Prüfgeräts 11. Nach dem Passieren der Eingangsschaltung 37 gelangt das Eingangssignal in einen Analog/Digital-Wandler 51. Das digitalisierte Ausgangssignal des Wandlers 51 wird der Signalauswertung 38, einem geschalteten Komparator 52 sowie einem weiteren Komparator 53 zugeleitet. Ein Ausgangssignal des weiteren Komparators 53 gelangt über eine Zeitverzögerung als Schaltsignal an den geschalteten Komparator 52.

Das erfindungsgemäße Verfahren wird anhand den in den Figuren 1 und 3 gezeigten Blockschaltbildern in Verbindung mit dem in Figur 2 gezeigten Signal näher erläutert:

Das erfindungsgemäße Verfahren beruht darauf, daß eine an der Meßleitung 32, 33 liegende Gleichspannungskomponente mit einer vorgebbaren Schwelle verglichen wird. Eine solche Gleichspannungskomponente ist nicht vorhanden, wenn eine induktive Signaleinkopplung oder die in Figur 1 gezeigte kapazitive Signaleinkopplung mit den Streukapazitäten 34, 35 vorliegt. Das an der Meßleitung 32, 33 abgreifbare Signal wird deshalb nach dem Passieren der Eingangsschaltung 37 dem Mittelwertbildner 40 zugeleitet. Falls eine analoge Signalverarbeitung vorgesehen ist, kann der Mittelwertbildner als eine Tiefpaßschaltung, vorzugsweise als eine Widerstands-Kondensator-Kombination realisiert sein. Der Mittelwertbildner ermittelt die Gleichspannungskomponente als gleitenden Mittelwert. Die Integrationszeit oder die Zeitkonstante des Tiefpaßfilters wird derart festgelegt, daß in Abstimmung mit dem an der Kontaktierung 30, 31 abnehmbaren Signal eine ausreichende Detektionssicherheit gewährleistet ist. Bei periodisch auftretenden Signalen muß die Integrationszeit oder die Zeitkonstante länger als eine Periode sein. Das vom Mittelwertbildner 40 abgegebene Signal wird im Komparator 41 mit einer fest vorgegebenen Schwelle verglichen. Sobald diese Schwelle überschritten wird, ist sichergestellt, daß die Meßleitung 32, 33 mit der Kontaktierung 30, 31 verbunden ist. In der Signalauswertung 38 wird das vom Komparator 41 abgegebene Signal bei der Auswertung des Meßergebnisses berücksichtigt. Signalfehlinterpretationen oder scheinbar vorhandene Meßergebnisse können mit dem erfindungsgemäßen Verfahren sicher unterdrückt werden. Die Festlegung der Schwelle hängt zweckmäßigerweise von dem erwarteten Signal ab.

Wenn als erwartetes Signal beispielsweise das in Figur 2 gezeigte Signal unterstellt wird, so ist die Schaltschwelle des Komparators 41 auf einen Wert festzulegen, der unterhalb der zweiten Schwelle 48 liegt. Der Wert muß in jedem Fall derart festgelegt werden, daß die vom Mittelwertbildner 40 ermittelte Gleichspannungskomponente die Schwelle mit Sicherheit überschreiten kann.

Bei dem in Figur 2 gezeigten Blockschaltbild ist eine digitale Signalverarbeitung im Meßgerät 11 zugrunde gelegt. Das Eingangssignal gelangt deshalb nach dem Passieren der Eingansschaltung 37 in den Analog/Digital-Wandler 51. Auch bei der digitalen Signalverarbeitung ist eine Mittelwertbildung möglich, die in Figur 3 nicht gezeigt ist. Die Mittelwertbildung findet in dem in Figur 1 gezeigten Mittelwertbildner 40 als Rechenverfahren statt, wobei der Vergleich mit der Schwelle in dem im Figur 1 gezeigten Komparator 41 ebenfalls durch arithmetische Operationen vorgenommen wird. Die Mittelwertbildung kann durch eine zeitbegrenzte Integration vorgegeben sein. Nach Ablauf einer vorgegebenen Zeit beginnt die Ingetration von neuem, wobei auch überlappende Integrationsintervalle vorgesehen sein können. Ebenso geeignet ist eine gleitende Mittelwertbildung.

Die in Figur 3 gezeigte digitale Signalverarbeitung ermöglicht eine Weiterbildung des Verfahrens, wobei das Eingangssignal zusätzlich daraufhin untersucht wird, ob es einen bestimmten Pegel überschreitet. Hierzu ist der weitere Komparator 52 vorgesehen, der das Signal mit dem vorgegebenen Pegel 44 vergleicht. Eine weitere Weiterbildung sieht vor, daß zusätzlich zur Schwellenüberschreitung der Gleichspannungskomponente und zusätzlich zur Pegelüberschreitung wenigstens eine weitere Schwelle 46, 48 nach Ablauf einer vorgebbaren Zeit 49, 50 überschritten sein muß. Nachdem sichergestellt ist, daß der Pegel 44 überschritten ist, wird nach Ablauf der von der Zeitverzögerung 54 vorgebbaren Zeit 49, 50 im geschalteten Komparator 52 festgestellt, ob das Eingangssignal die Schwelle 46, 48 überschreitet. Als Schwellen sind in Figur 2 beispielsweise die erste Schwelle 46 angegeben, die nach Ablauf der Zeit 49 überschritten sein muß. Weiterhin ist beispielsweise die zweite Schwelle 48 angegeben, die nach dem Ablauf der Zeit 50 überschritten sein muß. Es können sowohl eine als auch mehrere Schwellen 46, 48 vorgesehen sein. Der Komparator 52 wird deshalb als geschalteter Komparator 52 bezeichnet, weil ein Vergleich nur zu den angegebenen Zeitpunkten nach Ablauf der vorgegebenen Zeit 49, 50 vorgenommen wird. Eine andere Weiterbildung sieht vor, daß die eine oder die miteinander verknüpften Bedingungen mehrmals überschritten sein müssen, wobei die Vorgabezeit für die mehrmaligen Überschreitungen auf das erwartete Signal abzustellen ist.

## Patentansprüche

1. Verfahren zum Detektieren einer Kontaktierung von Meßleitungen eines elektronischen Meßgeräts mit einem Prüfling, dadurch gekennzeichnet, daß das an der Meßleitung (32, 33) liegende Signal zunächst einer Mittelwertbildung zum Ermitteln einer Gleichspannungskomponente unterworfen wird, daß die Gleichspannungskomponente anschließend mit einer vorgegebenen Schwelle verglichen wird und daß bei Überschreitung der Schwelle eine Kontaktierung erkannt wird.

2. Verfahren nach Anspruch 1, dadurch gekennzeichnet, daß die Gleichspannungskomponente durch eine zeitbegrenzte Integration des Signals ermittelt wird.

3. Verfahren nach Anspruch 1, dadurch gekennzeichnet, daß die Gleichspannungskomponente durch die Bildung eines gleitenden Mittelwerts ermittelt wird.

4. Verfahren nach einem der Ansprüche 1 bis 3, dadurch gekennzeichnet, daß das Signal einen vorgebbaren Pegel (44) überschreiten muß.

5. Verfahren nach Anspruch 4, dadurch gekennzeichnet, daß das Signal nach Ablauf wenigstens einer vorgebbaren Zeit (49, 50) nach der Pegelüberschreitung eine weitere vorgebbare Schwelle (46, 48) überschreiten muß.

## Claims

1. Method for detecting that contact is made between measuring leads of an electronic measuring device and a test object, characterized in that the signal present on the measuring lead (32, 33) is firstly subjected to averaging in order to determine a DC voltage component, in that the DC voltage component is subsequently compared with a predetermined threshold, and in that contact-making is detected when the threshold is exceeded.

2. Method according to Claim 1, characterized in that the DC voltage component is determined by means of time-limited integration of the signal.

3. Method according to Claim 1, characterized in that the DC voltage component is determined by means of the formation of a moving average.

4. Method according to one of Claims 1 to 3, characterized in that the signal must exceed a predeterminable level (44).

5. Method according to Claim 4, characterized in that the signal must exceed a further predeterminable threshold (46, 48) after the passing of at least one predeterminable period of time (49, 50) after the exceeding of the level.

## Revendications

1. Procédé pour détecter le contact entre les lignes de mesure d'un appareil de mesure électronique et un objet à contrôler,
procédé caractérisé en ce que
- on soumet le signal de la ligne de mesure (32, 33) tout d'abord à une opération de valeur moyenne pour déterminer une composante de tension continue,
- on compare la composante de tension continue à un seuil prédéterminé et,
- en cas de dépassement du seuil, on considère qu'il y a contact.

2. Procédé selon la revendication 1,
caractérisé en ce que
la composante de tension continue est obtenue par une intégration limitée dans le temps, du signal.

3. Procédé selon la revendication 1,
caractérisé en ce que
la composante de tension continue est obtenue en formant une valeur moyenne glissante.

4. Procédé selon l'une quelconque des revendications 1 à 3,
caractérisé en ce que
le signal doit dépasser un niveau (44) prédéterminé.

5. Procédé selon la revendication 4,
caractérisé en ce que
le signal doit dépasser au moins un autre seuil prédéterminé (46, 48) à la fin d'au moins une durée prédéterminée (49, 50) après le dépassement du niveau.
